Europäisches Patentamt

European Patent Office

Office européen des brevets

(19)

(11) Veröffentlichungsnummer : **0 557 327 B1**

## (12) EUROPÄISCHE PATENTSCHRIFT

(45) Veröffentlichungstag der Patentschrift :
25.01.95 Patentblatt 95/04

(51) Int. Cl.$^6$ : **G01R 27/26, F02D 19/08**

(21) Anmeldenummer : **91919451.4**

(22) Anmeldetag : **11.11.91**

(86) Internationale Anmeldenummer :
**PCT/EP91/02133**

(87) Internationale Veröffentlichungsnummer :
**WO 92/08991 29.05.92 Gazette 92/12**

(54) MESSGERÄT ZUM BESTIMMEN DES ALKOHOLGEHALTES EINES GEMISCHES.

(30) Priorität : **16.11.90 DE 9012197 U**

(43) Veröffentlichungstag der Anmeldung :
**01.09.93 Patentblatt 93/35**

(45) Bekanntmachung des Hinweises auf die
Patenterteilung :
**25.01.95 Patentblatt 95/04**

(84) Benannte Vertragsstaaten :
**DE FR GB IT SE**

(56) Entgegenhaltungen :
**EP-A- 0 285 070**

(56) Entgegenhaltungen :
EP-A- **0 335 168**
GB-A- **2 058 364**
**Patent Abstracts of Japan, Band 8, Nr. 137
(P-282)[1574], 26. Juni 1984, & JP,A, 5937464
(SEIKO) 29. Februar 1984, siehe die Zusammenfassung**

(73) Patentinhaber : **SIEMENS
AKTIENGESELLSCHAFT
Wittelsbacherplatz 2
D-80333 München (DE)**

(72) Erfinder : **BRABETZ, Ludwig
14, rue Gaston-Doumergue
F-31170 Tournefeuille (FR)**

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

## Beschreibung

Die Erfindung betrifft ein Meßgerät nach dem Oberbegriff von Anspruch 1 und ein Verfahren nach dem Oberbegriff von Anspruch 6.

In der Patentanmeldung EP 0 335 168 ist ein Verfahren zum Betrieb einer Brennkraftmaschine, die mit einem Alkohol-Benzin-Gemisch betrieben wird, beschrieben. Die Messung des Alkoholgehalts eines zugeführten Gemischs dient zu einer Vorsteuerung der zugeführten Gemischmenge. Der Alkoholgehalt des Gemischs wird durch Messen der Kapazität und des Verlustwiderstandes (im folgenden durch den Leitwert ausgedrückt) einer Meßanordnung, die von dem Gemisch durchflossen wird, in einer gemeinsamen Meßschaltung bestimmt. Diese Meßschaltung ist schwingungsfähig und ihre Frequenz wird als Maß der Kapazität ausgewertet. Vorzugsweise wird die Meßanordnung als frequenzbestimmendes Glied eines Oszillators verwendet, dessen Frequenz durch die Parallelschaltung eines weiteren Kondensators oder durch eine schaltbare Verzögerung geändert werden kann.

Der Oszillator arbeitet bei hohen Frequenzen und liefert ein weitgehend von der Kapazität der Meßanordnung bestimmtes Signal. Dieses Signal hängt auch von dem Leitwert ab, der die Verluste des Kondensators darstellt. Trotz der Verwendung sehr schneller Bauteile ist die Laufzeit des Signals von einem Eingang des Oszillators zu dessen Ausgang nicht mehr zu vernachlässigen. Bedingt durch Bauteiletoleranzen kann diese Laufzeit variieren.

Da die Laufzeit auch noch abhängig ist von der Temperatur und der Versorgungsspannung und außerdem eine Langzeitdrift besitzt, ist ein hoher Aufwand zum Bestimmen der Kapazität der Meßanordnung erforderlich.

Der Erfindung liegt die Aufgabe zugrunde, ein Meßgerät und ein Verfahren der eingangs genannten Art zu schaffen, die es ermöglichen, die Kapazität der Meßanordnung unter Berücksichtigung der Bauteiletoleranzen zu bestimmen.

Diese Aufgabe wird erfindungsgemäß durch ein Meßgerät mit den Merkmalen von Anspruch 1 und durch ein Verfahren mit den Merkmalen von Anspruch 6 gelöst.

Weitere Ausgestaltungen der Erfindung sind in den Unteransprüchen beschrieben.

Die Vorteile der Erfindung liegen unter anderem darin, daß das Meßgerät aus preiswerten und einfachen Bauelementen aufgebaut ist. Das Meßgerät weist eine Meßanordnung und eine Meßschaltung auf. Die Meßschaltung besteht aus einem Oszillator und einer Steuerschaltung. Der Oszillator weist einen Komparator auf, der nur mit einem RC-Netzwerk beschaltet ist. Die Meßanordnung ist ein Teil des RC-Netzwerks. Mit nur einem Sensorelement kann die Kapazität und der Leitwert der Meßanordnung bestimmt werden.

Der Oszillator schwingt mit einer Frequenz, die innerhalb eines Meßzyklus durch die Steuerschaltung verändert wird. Die Frequenz wird zur Bestimmung der Kapazität und des Leitwerts ausgewertet. In der Steuerschaltung wird ein handelsübliches Gatter verwendet, das Tristate-Ausgänge hat oder ein integrierter Schaltkreis mit Halbleiterschaltern. Das Gatter und der Schaltkreis sind nur mit einem Widerstandsnetzwerk beschaltet. Die Meßschaltung kann auch als anwendungsspezifischer integrierter Schaltkreis (ASIC) realisiert sein.

Zwei Ausführungsbeispiele der Erfindung sind in der Zeichnung dargestellt und werden im folgenden näher beschrieben. Es zeigen:

Figur 1:  ein Meßgerät zum Bestimmen des Alkoholgehalts eines Gemischs,

Figur 2:  eine Meßschaltung des Meßgerätes nach Figur 1,

Figur 3a und 3b:  zwei Ersatzschaltbilder der Meßschaltung nach Figur 2 für zwei verschiedene Zustände einer Steuerschaltung,

Figur 4:  eine weitere schematisch dargestellte, erfindungsgemäße Meßschaltung des Meßgerätes nach Figur 1,

Figur 5:  die relative Dielektrizitätskonstante $\varepsilon_r$ in Abhängigkeit des Alkoholgehalts eines Gemischs bei einer Gemischtemperatur von T = 20°C und

Figur 6:  die relative Dielektrizitätskonstante $\varepsilon_r$ in Abhängigkeit der Temperatur T für Gemische mit unterschiedlichem Alkoholgehalt.

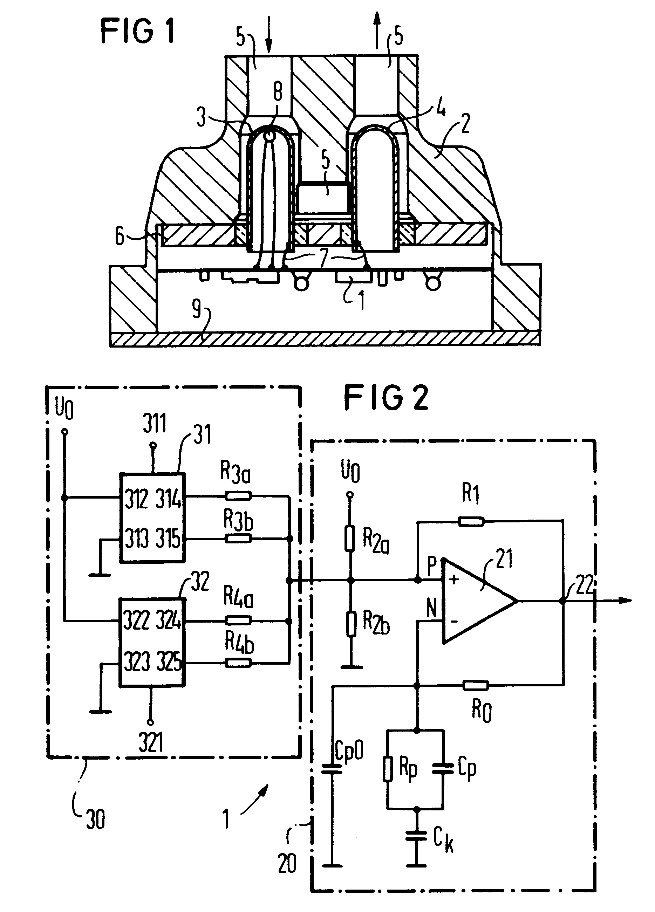

Ein Meßgerät (Figur 1) zum Bestimmen des Alkoholgehalts eines Gemischs weist eine Meßanordnung und eine Meßschaltung 1 auf. Die Meßanordnung besteht aus einem Gehäuse 2 und weist beispielsweise zwei Sensorelemente 3 und 4 auf. Das Gemisch, in dem Alkohol und Benzin enthalten sind, strömt in einem Kraftstoffkanal 5 durch das Gehäuse 2 in der mit den Pfeilen angegebenen Richtung. Die Sensorelemente 3 und 4 sind in einer Zwischenplatte 6 eingeglast und über einen Draht 7 elektrisch mit der Meßschaltung 1 verbunden. In dem ersten Sensorelement 3 befindet sich ein Temperatursensor 8 zum Messen der Gemischtemperatur. Das Gehäuse 2 ist durch eine Bodenplatte 9 verschlossen.

Ein Teil der Wandung des Gehäuses 2 bildet eine erste Elektrode und das Sensorelement 3 eine zweite Elektrode eines Kondensators $C_p$, dessen Kapazität gemessen wird. Das Gemisch umströmt die Sensorelemente 3 und 4 und bildet dabei das Dielektrikum des Kondensators $C_p$. Aus der Kapazität des Kondensators $C_p$ wird die relative Dielektrizitätskonstante $\varepsilon_r$ des Gemisch berechnet.

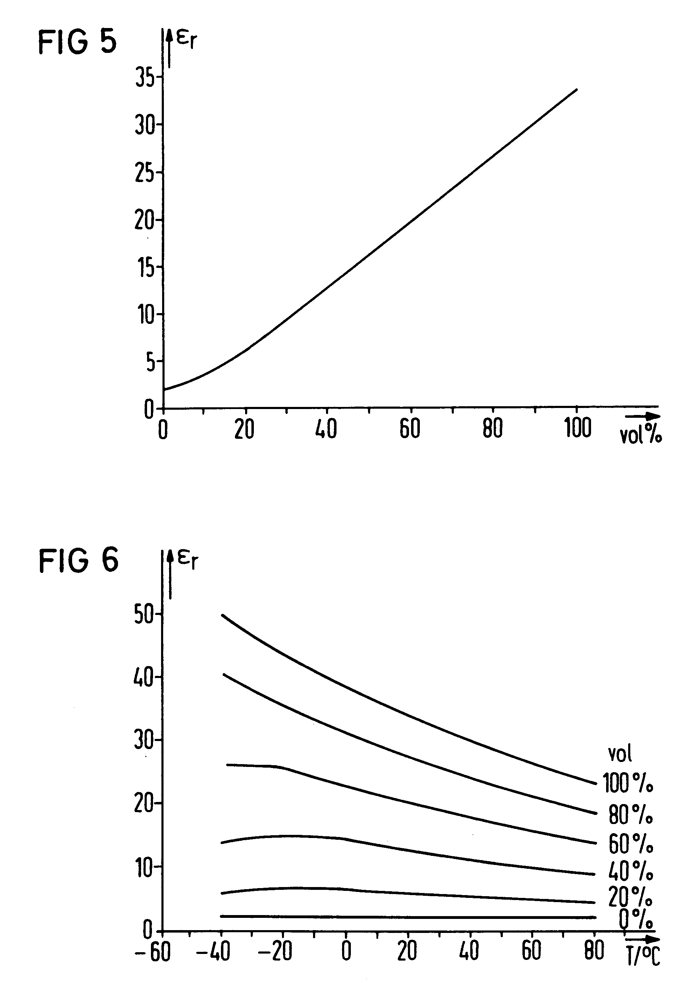

Das Gemisch setzt sich aus den Volumenanteilen von Alkohol und Benzin zusammen. Alkohol und Benzin haben unterschiedliche Dielektrizitätskonstanten. Der Zusammenhang zwischen der relativen Dielektrizitätskonstanten $\varepsilon_r$ des Gemischs und dem Volumenanteil von Alkohol in Vol % ist bei einer Gemischtemperatur von T = 20°C in Figur 5 gezeigt. Die Abhängigkeit der relativen Dielektrizitätskonstanten $\varepsilon_r$ von der Gemischtemperatur T in Grad Celsius (°C) ist bei verschiedenen Volumenanteilen von Alkohol in Volumen-Prozent (Vol %) in Figur 6 dargestellt. Aus der Kenntnis der resultierenden relativen Dielektrizitätskonstanten $\varepsilon_r$ des Gemischs kann somit der Alkoholgehalt ermittelt werden.

Mit dem ersten Sensorelement 3 (Figur 1) wird die Kapazität des Kondensators $C_p$ gemessen. Um sekundäre Einflüsse, wie z.B. Verschmutzung des Gemischs, bei der Messung zu kompensieren, wird der Leitwert $R_p$ der Meßanordnung, der den Widerstand des Dielektrikums und somit die Verluste des Kondensators $C_p$ darstellt, mit dem zweiten Sensorelement 4 gemessen und damit die Messung der Kapazität des Kondensators $C_p$ rechnerisch oder schaltungstechnisch korrigiert. Weist die Meßanordnung nur ein Sensorelement auf, so werden die Kapazität des Kondensators $C_p$ und der Leitwert $R_p$ mit diesem nacheinander gemessen.

Die Sensorelemente 3 und 4 sind aus einer Nickel-Eisen-Legierung hergestellt und haben eine dünne Wandstärke. Dieses Material hat den Vorteil, daß eine Kontaktierung mit einem Draht 7 zur Meßschaltung 1 hin gut möglich ist. Je ein Draht 7 ist an das Sensorelement 3 und 4 angeschweißt und jeweils in der Meßschaltung 1 verlötet. Somit stellen die Sensorelemente 3 oder 4 eine elektrische Verbindung zwischen dem Kondensator $C_p$ und der Meßschaltung 1 dar. Durch die dünne Wand des Sensorelements 3 findet eine guter Wärmeübergang zu dem Temperatursensor 8 statt. Somit wird bei dem Bestimmen des Alkoholgehalts die Temperaturabhängigkeit der relativen Dielektrizitätskonstanten $\varepsilon_r$ berücksichtigt (vgl. Figur 6).

Die beiden Sensorelemente 3 und 4 sind gleich aufgebaut. Sie haben einen weitgehend gleichen Abstand zum Gehäuse 2. Sie sind durch eine Einglasung vom Gehäuse 2 elektrisch und thermisch isoliert.

Das Gehäuse 2 wird aus Aluminium im Druckguß hergestellt. Da das Gemisch chemisch sehr aggressiv sein kann, wird das Gehäuse 2 mit Kupfer und Nickel beschichtet. Dadurch bietet das Gehäuse 2 zusammen mit der Bodenplatte 9 auch eine Abschirmung gegen elektromagnetische Felder.

In dem Meßgerät nach Figur 1 wird die Kapazität des Kondensators $C_p$ und der Leitwert $R_p$ der Meßanordnung mit zwei Sensorelementen 3 und 4 bestimmt. Je nach Anwendung kann zum Bestimmen des Alkoholgehalts des Gemischs auch ein Meßgerät eingesetzt werden, dessen Meßanordnung nur ein Sensorelement aufweist. Dabei werden die Kapazität des Kondensators $C_p$ und der Leitwert $R_p$ zeitlich nacheinander gemessen. Die Meßschaltung 1 kann an jede von den beiden Meßanordnungen angeschlossen werden.

Die Meßschaltung 1 (Figur 2) besteht aus einem Oszillator 20 und einer Steuerschaltung 30, die dem Oszillator vorgeschaltet ist. Der Oszillator 20 enthält einen Komparator 21 und ein RC-Netzwerk, mit dem der Komparator beschaltet ist. Der Ausgang 22 des Komparators 21 ist über einen Widerstand $R_1$ auf den positiven Eingang (P-Eingang) des Komparators und über einen Widerstand $R_0$ auf den negative Eingang (N-Eingang) zurückgekoppelt.

Der Ausgang 22 führt auch zu einem nicht in der Figur 2 gezeichneten Mikrocontroller. Dort findet die Auswertung der Meßergebnisse statt, d.h. das Bestimmen der Kapazität des Kondensators $C_p$ sowie der relativen Dielektrizitätskonstanten $\varepsilon_r$ und damit des Alkoholgehalts des Gemischs.

Die Meßanordnung, die durch den Kondensator $C_p$ und den Leitwert $R_p$ dargestellt wird, ist ein Teil des RC-Netzwerks. Sie ist mit dem N-Eingang des Komparators 21 verbunden. Über einen in Serie geschalteten Koppel-Kondensator $C_k$ ist die Meßanordnung mit Masse verbunden. Parallel zur Meßanordnung liegt ein weiterer Kondensator $C_{p0}$ gegen Masse.

Mit dem P-Eingang des Komparators 21 ist der Mittelabgriff eines Spannungsteilers über einen Widerstand $R_{2a}$ mit der Versorgungsspannung $U_0$ und über einen Widerstand $R_{2b}$ mit Masse verbunden.

Die Steuerschaltung 30 besteht aus den Widerständen $R_{3a}$, $R_{3b}$, $R_{4a}$ und $R_{4b}$ sowie zwei Gattern 31 und 32, die Tristate-Ausgänge 314, 315, 324 und 325 haben. Die Gatter 31 und 32 werden über Enable-Eingänge 311 bzw. 321 von dem Mikrocontroller getrennt voneinander angesteuert. Wenn die Enable-Eingänge 311 und 321 auf logisch "High" liegen, werden die logischen Pegel an den Eingängen 312, 313, 322 und 323 auf die Ausgänge 314, 315, 324 bzw. 325 durchgeschaltet (die Gatter sind "enabled").

Liegen die Enable-Eingänge 311 oder 321 auf einem logischen "Low"-Pegel, so werden die Gatter 31 bzw. 32 gesperrt ("disabled") und die Ausgangswiderstände der Ausgänge 314 und 315 bzw. 324 und 325 der Gatter nehmen einen hochohmigen Zustand ein.

Die Steuerschaltung 30 nimmt je nach Ansteuern der zwei Enable-Eingänge 311 und 321 vier verschiedene Zustände ein, d.h. es werden vier verschiedene Steuerspannungen erzeugt. Im ersten Zustand ist das Gatter 31 disabled und das Gatter 32 enabled, im zweiten Zustand sind beide Gatter disabled, im dritten Zustand ist das Gatter 32 disabled und das Gatter 31 enabled und im vierten Zustand sind beide Gatter enabled.

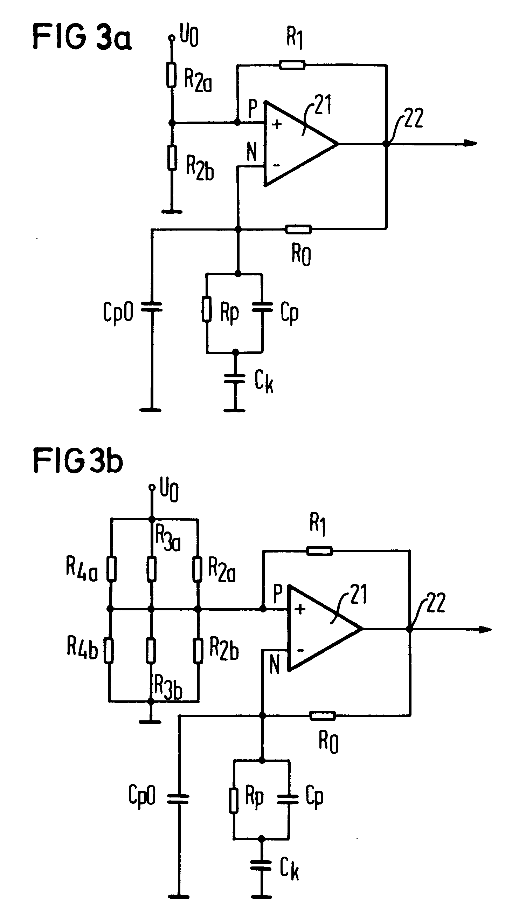

Die Ausgänge 314, 315, 324 und 325 der Gatter 31 und 32 sind über die Widerstände $R_{3a}$, $R_{3b}$, $R_{4a}$ bzw. $R_{4b}$ mit dem P-Eingang verbunden. Sind beispielsweise die Gatter 31 und 32 disabled (Figur 2), so wirken sich die hochohmigen Ausgangswiderstände wie ein Leerlauf an dieser Stelle aus. Als Ersatzschaltbild ergibt sich Figur 3a. Die Widerstände $R_{3a}$, $R_{3b}$, $R_{4a}$ und $R_{4b}$ haben in diesem Zustand keinen Einfluß auf die Meßschaltung 1. Lediglich die Widerstände $R_{2a}$ und $R_{2b}$ bestimmen die Eingangsspannung U+ an dem P-Eingang des Komparators 21.

Sind beispielsweise die Gatter 31 und 32 enabled (Figur 2), so werden die Eingangsspannungen auf die Ausgänge der Gatter durchgeschaltet, d.h. der "High"-Pegel liegt direkt an den Ausgängen 314 und 324 und der "Low"-Pegel an den Ausgängen 315 und 325.

Das Ersatzschaltbild für diesen Zustand ist in Figur 3b dargestellt. Ein Innenwiderstand der Gatter 31 oder 32, der jeweils in Reihe zu den Widerständen $R_{3a}$, $R_{3b}$, $R_{4a}$ und $R_{4b}$ liegt, kann vernachlässigt werden, da die Widerstände $R_{3a}$, $R_{3b}$, $R_{4a}$ und $R_{4b}$ viel größer als der Innenwiderstand dimensioniert sind. Damit liegt die Versorgungsspannung $U_0$ direkt an den Ausgängen 314 und 324 und Masse an den Ausgängen 315 und 325. In diesem Zustand wird die Eingangsspannung U+ (Steuerspannung) am P-Eingang des Komparators 21 durch drei parallel geschaltete Spannungsteiler mit den Widerständen $R_{2a}$, $R_{2b}$, $R_{3a}$, $R_{3b}$, $R_{4a}$ und $R_{4b}$ bestimmt.

Die Widerstände $R_{2a}$, $R_{2b}$, $R_{3a}$, $R_{3b}$, $R_{4a}$ und $R_{4b}$ sind jeweils paarweise gleich groß, d.h. $R_{2a} = R_{2b}$, $R_{3a} = R_{3b}$ usw. Damit ist gewährleistet, daß in jedem Zustand der gleiche Arbeitspunkt am P-Eingang des Komparators 21 vorliegt, d.h. am P-Eingang befindet sich in jedem Zustand ein mittleres Spannungspotential symmetrisch zwischen der Versorgungsspannung $U_0$ und Masse. In diesem Ausführungsbeispiel sind die Widerstände $R_{2a} = R_{2b} = R_{3a} = R_{3b} = R_{4a} = R_{4b}$ etwa 200 Ω. Dadurch liegt der Arbeitspunkt des Komparators 21 bei etwa +2,5 V bei einer Versorgungsspannung $U_0$ = +5 V.

Der Widerstand $R_1$ beträgt etwa 200 n und der Widerstand $R_0$ etwa 680 Ω. Die Gatter 31 und 32 werden mit Bus-Treiber vom Typ 74 ACT 245 der Fa. National Semiconductor realisiert. Als Komparator 21 wird der Baustein CF72220 der Fa. Texas Instruments verwendet. Die Meßschaltung 1 kann auch komplett als ein anwendungsspezifischer integrierter Schaltkreis (ASIC = Application Specific Integrated Circuit) realisiert sein.

Durch das Auf- und Entladen der Kondensatoren $C_p$ und $C_{p0}$ wird bewirkt, daß das Ausgangssignal des Komparators 21 über eine Rückkopplung verzögert auf seine beiden Eingänge P-Eingang und N-Eingang gelangt. Dadurch schwingt der Oszillator 20 mit einer Oszillatorfrequenz f oder mit einer Periodendauer T und seine Übertragungskennlinie weist eine Hysteresekurve auf.

Um die Meßanordnung gleichspannungsmäßig zu entkoppeln und den Arbeitspunkt symmetrisch an den P-Eingang zu legen, wird der Koppel-Kondensator $C_k$ in Reihe zu der Parallelschaltung des Kondensators $C_p$ und des Leitwerts $R_p$ gegen Masse geschaltet. Die Kapazität des Kondensators $C_p$ beträgt etwa zwischen 6pF und 120 pF. Sie hängt von dem Alkoholgehalt des Gemischs ab. Der Verlustwiderstand, hier als Leitwert $R_p$ bezeichnet, ist größer als etwa 500 Ω. Die Kapazität des Koppel-Kondensators $C_k$ beträgt etwa 100 nF. Da die Kapazität des Koppel-Kondensators $C_k$ sehr viel größer ist als die Kapazität des Kondensators $C_p$ und die beiden Kondensatoren $C_k$ und $C_p$ in Reihe geschaltet sind, kann der Koppel-Kondensator $C_k$ bei dem Bestimmen der Kapazität des Kondensators $C_p$ vernachlässigt werden.

Die Steuerspannung am P-Eingang des Komparators 21 schwingt symmetrisch um den Arbeitspunkt und ist abhängig von den verschiedenen Zuständen der Steuerschaltung 30. Es gilt folgender Zusammenhang:

$$U_{+n} = U_a / (1 + R_1 * \sum_{i=2}^{n} (1/R_{ia} + 1/R_{ib})) := \alpha_n * U_a \qquad (1)$$

mit $U_{+n}$ ist Steuerspannung am P-Eingang und $R_{ia}$ und $R_{ib}$ bedeuten $R_{2a}$ bzw. $R_{2b}$ für i= 2, entsprechendes gilt für i = 3 und 4.

Für die Zustände n = 2, 3 und 4 beschreibt die Gleichung (1) die Steuerspannung am P-Eingang, wenn die Steuerschaltung 30 den zweiten, den dritten bzw. den vierten Zustand einnimmt. $\alpha_n$ ist eine Konstante, die bei der oben erwähnten Dimensionierung der Widerstände im zweiten Zustand $\alpha_2$ = 1/3, im dritten Zustand $\alpha_3$ = 1/5 und im vierten Zustand $\alpha_4$ = 1/7 beträgt.

Die Eingangsspannung U_ am N-Eingang wird durch eine Differentialgleichung beschrieben:
$$U_a = U\_ * (1 + R_0/R_p) + dU\_/dt * R_0 * C_p \quad (2)$$
wobei der Ausdruck $dU\_/dt$ die zeitliche Ableitung der Eingangsspannung U_ bedeutet.

Der Arbeitspunkt der Meßschaltung 1 wird durch die Spannungsteiler am P-Eingang eingestellt und setzt voraus, daß die Ausgangsspannung $U_a$ symmetrisch dazu nur zwei Werte annehmen kann mit einem Ausgangsspannungshub $\hat{u}_a$. Für die Ausgangsspannung $U_a$ im Arbeitspunkt gilt:

$$U_a = \begin{cases} \hat{u}_a/2 & \text{für } m*T < t \leq (m+1/2)*T \\ -\hat{u}_a/2 & \text{für } (m+1/2)*T < t \leq (m+1)*T \end{cases} \quad (3)$$

mit m = 1,2,...(ganze Zahl; Anzahl der Perioden),
T = Periodendauer und
t = Zeit.

Mit der Gleichung (1) ergibt sich die Steuerspannung $U_+$ am P-Eingang mit einer Periodendauer $T_n$ für jeden Zustand der Steuerschaltung 30 zu:

$$U_{+n} = \alpha_n * \begin{cases} \hat{u}_a/2 & \text{für } m*T_n < t \leq (m+1/2)*T_n \\ -\hat{u}_a/2 & \text{für } (m+1/2)*T_n < t \leq (m+1)*T_n \end{cases} \quad (4)$$

und die Eingangsspannung $U_-$ am N-Eingang zu

$$U_- = \begin{cases} U_a*R_p/(2*(R_0+R_p))-\hat{u}_-*\exp(-t/(R*C_p)) & \text{für } m*T<t\leq(m+1/2)*T \\ -U_a*R_p/(2*(R_0+R_p))+\hat{u}_-*\exp(-t/(R*C_p)) & \text{für } (m+1/2)*T<t\leq(m+1)*T \end{cases} \quad (5)$$

mit $R = R_0\|R_p = R_0*R_p/(R_0+R_p)$
und $\hat{u}_-$ = Eingangsspannungshub am N-Eingang.

Die Eingangsspannung $U_-$ schwingt mit der Oszillatorfrequenz f und der Periodendauer T in einer Hysteresekurve symmetrisch um den Arbeitspunkt mit den in der Gleichung (5) angegebenen zwei Spannungswerten (Schaltspannung).

Berücksichtigt man eine Laufzeit L des Komparators 21, d.h. die Zeit, die ein Signal zum Durchlaufen von einem Eingang zu dem Ausgang 22 des Komparators benötigt, so lauten die Randbedingungen für die Lösung der Gleichung (5) und damit für die Eingangsspannung $U_-$ wie folgt:

$$U_-(t = T/2 - L) = U_+(t = T/2 - L) = \alpha_n * U_a/2 \quad (6)$$

$$U_-(t = 0) = -U_-(t = T/2) \quad (7)$$

Die Gleichung (6) drückt aus, daß die Schaltspannung bereits um die Laufzeit L früher als der Umschaltzeitpunkt erreicht wird. Die Gleichung (7) berücksichtigt, daß die Eingangsspannung $U_-$ zum Zeitpunkt t=0 nicht bei der Schaltspannung liegt, sondern bei einer über diese hinaus in der Laufzeit L erreichten Spannung. Werden die Randbedingungen in der Gleichung (5) berücksichtigt, so kann diese Gleichung nach der Periodendauer T aufgelöst werden. Für die Zustände n = 2, 3 und 4 ergibt sich die Periodendauer $T_n$:

$$T_n = 2 * (L + R * C_p * \ln(2/(1 - \alpha_n * (R + R_p)/R_p) * \exp(- L/(R * C_p)))) \quad (8)$$

In jedem Zustand der Steuerschaltung 30 ergibt sich eine andere Oszillatorfrequenz f und damit eine andere Periodendauer $T_n$ sowie eine andere Hysteresekurve. In der Gleichung (8) sind drei unbekannte Parameter, und zwar die zu messende Kapazität des Kondensators $C_p$ und der dazugehörige Leitwert $R_p$ sowie die Laufzeit L. Alle anderen Parameter sind bekannt. Um die drei Unbekannten zu bestimmen, werden innerhalb eines Meßzyklus drei verschiedene Gleichungen benötigt. Dies geschieht dadurch, daß über den Mikrocontroller die drei Zustände der Steuerschaltung 30 eingestellt werden und in jedem Zustand die Periodendauer $T_n$ gemessen wird.

Aus der Gleichung (8) ergibt sich, daß die Ausgangsspannung $U_a$ des Komparators 21 nicht die Periodendauer $T_n$ beeinflußt. Demzufolge sind Streuungen der Ausgangsspannung $U_a$ und des Ausgangswiderstands des Komparators 21 ohne Bedeutung, ebenso Schwankungen über der Temperatur, der Zeit und der Versorgungsspannung $U_0$.

Aufgrund von Bauteiletoleranzen kann die Laufzeit L eines Signals von einem Eingang des Komparators 21 zu dessen Ausgang 22 variieren. Da die Laufzeit L in jedem Meßzyklus berücksichtigt wird, können der Kondensator $C_p$ und der Leitwert $R_p$ weitgehend unabhängig von Bauteiletoleranzen des Komparators 21 bestimmt werden. Daher kann in der Meßschaltung 1 ein preiswerter Komparator 21 ohne Genauigkeitseinbuße eingesetzt werden.

Mit dieser Meßschaltung 1 werden kleine Kapazitäten gemessen. Da die Auf- und Entladezeiten solcher Kondensatoren sehr klein sind, würde der Oszillator 20 mit einer hohe Oszillatorfrequenz f schwingen. Dies würde wiederum schnelle und damit teure Bauteile bedingen. Da die Oszillatorfrequenz f der Schwingung begrenzt ist durch die endliche Laufzeit L des Komparators 21, kann die Kapazität des Kondensators $C_p$ nur dann genau gemessen werden, wenn die Oszillatorfrequenz f der Schwingung verkleinert wird. Hierzu wird dem zu bestimmenden Kondensator $C_p$ der bekannte Kondensator $C_{p0}$ parallel geschaltet und damit die zu messende Kapazität vergrößert, d.h. die beiden Kapazitäten der Kondensatoren $C_p$ und $C_{p0}$ addieren sich. Die Auf- und Entladezeiten vergrößern sich. In der Gleichung (8) muß dann die Kapazität des Kondensators $C_p$ durch die Kapazität des Kondensators $C_p + C_{p0}$ ersetzt werden.

Die Kapazität des Kondensators $C_{p0}$ beträgt in diesem Ausführungsbeispiel etwa 30 pF. Damit ergibt sich die zu bestimmende Kapazität etwa zwischen 36 pF und 150 pF. Um die Kapazität des Kondensators $C_p$ zu erhalten, wird die Kapazität des Kondensators $C_{p0}$ bei der Auswertung der Meßergebnisse beispielsweise im Mikrocontroller rechnerisch berücksichtigt.

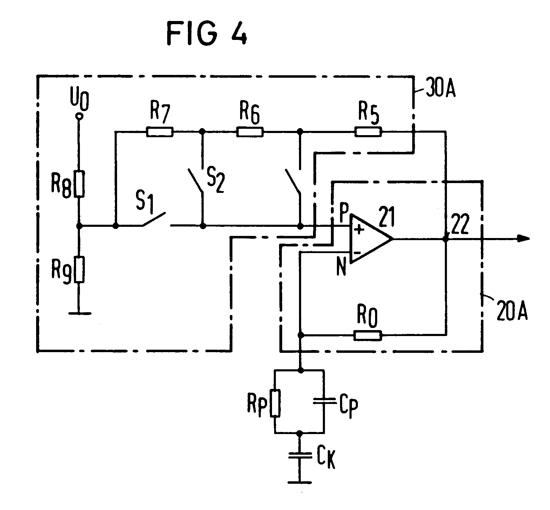

Ein weiteres Ausführungsbeispiel der Erfindung ist in der Figur 4 dargestellt. In der Figur 4 haben die Teile, die schon anhand der Figuren 1 und 2 beschrieben worden sind, die gleichen Bezugszeichen erhalten.

Eine Steuerschaltung 30A mit Schaltern $S_1$, $S_2$ und $S_3$ sowie mit Widerstandteilern mit Widerständen $R_5$, $R_6$, $R_7$, $R_8$ und $R_9$ ist über den P-Eingang und den Ausgang des Komparators 21 mit einem Oszillator 20A verbunden. Die Meßanordnung, die durch den Kondensator $C_p$ und den Leitwert $R_p$ dargestellt wird, ist mit dem N-Eingang des Komparators 21 verbunden. Über den in Serie geschalteten Koppel-Kondensator $C_k$ ist die Meßanordnung mit Masse verbunden. Der Ausgang 22 des Komparators 21 ist über den Widerstand $R_0$ auf den N-Eingang und über die Steuerschaltung 30A auf den P-Eingang des Komparators zurückgekoppelt.

Die Schalter $S_1$ bis $S_3$ werden von dem in Figur 4 nicht dargestellten Mikrocontroller gesteuert. Je nach Stellung der Schalter $S_1$ bis $S_3$ wird dem P-Eingang des Oszillators 20A durch das Teilungsverhältnis an den Widerstandteilern eine andere Steuerspannung zugeführt. Die Steuerspannung bestimmt die Hysteresekurve des Oszillators 20A und damit die sich einstellende Oszillatorfrequenz f. Analog zu Gleichung (8) müssen auch hier die drei unbekannten Parameter bestimmt werden, wozu über den Mikrocontroller die drei Zustände durch die verschiedenen Steuerspannungen eingestellt werden sowie in jedem Zustand die Periodendauer $T_n$ und damit die Oszillatorfrequenz gemessen wird.

Statt Tristate-Gatter 31 und 32 in der Steuerschaltung einzusetzen, werden bei diesem Ausführungsbeispiel die Schalter $S_1$ bis $S_3$ als Halbleiterschalter realisiert, deren Durchgangswiderstände viel kleiner sind als der Eingangswiderstand des Komparators 21 und somit außer acht gelassen werden können. Parasitäre Kapazitäten der Schalter $S_1$ bis $S_3$ werden durch eine Integration der gesamten Meßschaltung 1 als ASIC auf vernachlässigbare Werte minimiert. Ebenso sind auf dem ASIC (in der Figur 4 nicht dargestellte) zur Messung der Periodendauer $T_n$ nötige Teiler und Zähler, eine von dem Mikrocontroller gesteuerte Logikschaltung, ein Quarzoszillator, ein Meßoszillator für die Temperaturmessung des Gemischs sowie eine Interfaceschaltung zum Steuern und zur Datenübergabe als Schaltkreis integriert.

Das erfindungsgemäße Meßgerät hat über das oben erwähnte technische Gebiet hinaus weitere Anwendungsbereiche auf dem Gebiet der kapazitiven Sensoren. Die Meßschaltung 1 kann beispielsweise eingesetzt werden bei einem chemischen Sensor für die Analyse von Flüssigkeiten, die zwei Komponenten enthalten, bei einem Füllstandsmesser, bei einem Wegaufnehmer, einem Drucksensor, einem Berührungsmelder oder bei einem schnellen Temperaturmeßgerät bei einer Flüssigkeit mit einem bekannten Dielektrikum.

Der in der obigen Beschreibung benutzte Begriff "Leitwert" ist gleichbedeutend mit dem Begriff "Verlustwiderstand".

**Patentansprüche**

1. Meßgerät zum Bestimmen des Alkoholgehaltes eines Gemisches durch Messen der Kapazität und des Leitwertes eines Kondensators, der aus
   - einer ersten Elektrode, die von einem Teil der Wandung eines Gehäuses (2) gebildet wird und
   - einer zweiten Elektrode, die von einem von dem Gemisch umströmten Sensorelement (3) gebildet wird besteht; und
   mit einer Meßschaltung (1), die mit dem Kondensator (2,3) elektrisch verbunden ist und einen Oszillator (20) enthält, aus dessen Frequenz die Kapazität des Kondensators (2,3) ermittelt wird,
   **dadurch gekennzeichnet,**
   - daß ein Eingang (P) des Oszillators (20) mit einer Steuerschaltung (30) verbunden ist, von der mindestens drei verschiedene Steuerspannungen für den Oszillator (20) verzeugt werden,

- daß der Ausgang des Oszillators (20) mit einer Auswerteschaltung verbunden ist, durch welche die sich bei jeder dieser Spannungen einstellende Oszillatorfrequenz gemessen wird, und
- daß aus den gemessenen Oszillatorfrequenzen die Kapazität ($C_p$)und der Leitwert ($R_p$) des Kondensators (2, 3) ermittelt werden.

2. Meßgerät nach Anspruch 1, dadurch gekennzeichnet, daß die mit dem Ausgang des Oszillators (20) verbundene Auswerteschaltung ein Mikrocontroller ist.

3. Meßgerät nach Anspruch 1, dadurch gekennzeichnet, daß die mit dem Ausgang des Oszillators (20) verbundene Auswerteschaltung ein Mikrocontroller ist, durch den aus den gemessenen Oszillatorfrequenzen die Laufzeit (L) des Oszillators (20) ermittelt wird.

4. Meßgerät nach Anspruch 1, dadurch gekennzeichnet, daß der Oszillator (20) einen Komparator (21) enthält, der mit einem RC-Netzwerk beschaltet ist.

5. Meßgerät nach Anspruch 1, dadurch gekennzeichnet, daß die Steuerschaltung (30) mindestens ein Gatter (31, 32) enthält, das Tristate-Ausgänge (314, 315, 324, 325) aufweist und das mit einem Widerstandsnetzwerk beschaltet ist.

6. Verfahren zum Bestimmen des Alkoholgehalts eines Gemischs mit dem Meßgerät nach einem der vorhergehenden Ansprüche, dadurch gekennzeichnet, daß in der Steuerschaltung (30) Steuerspannungen erzeugt werden, die dem Oszillator (20) zugeführt werden, und daß durch Ändern der Steuerspannung mindestens drei Oszillatorfrequenzen erzeugt werden, aus denen eine entsprechende Anzahl Parameter der Meßschaltung (1) ermittelt werden. werden.

7. Verfahren nach Anspruch 6, dadurch gekennzeichnet, daß aus den gemessenen Oszillatorfrequenzen die Kapazität und der Leitwert des Kondensators und aus der Kapazität und aus dem Leitwert die relative Dielektrizitätskonstante ($\varepsilon_r$) des Gemischs ermittelt werden.

## Claims

1. Measuring instrument for determining the alcohol content of a mixture by measuring the capacitance and the conductance of a capacitor which comprises
   - a first electrode which is formed by a part of the wall of a casing (2), and
   - a second electrode which is formed by a sensor element (3) around which the mixture flows, and
   having a measuring circuit (1) which is electrically connected to the capacitor (2, 3) and contains an oscillator (20) from whose frequency the capacitance of the capacitor (2, 3) is determined, characterized
   - in that an input (P) of the oscillator (20) is connected to a control circuit (30) by which at least three different control voltages for the oscillator (20) are generated,
   - in that the output of the oscillator (20) is connected to an evaluation circuit by means of which the oscillator frequency set up for each of these voltages is measured, and
   - in that the capacitance (Cp) and the conductance (Rp) of the capacitor (2, 3) are determined from the measured oscillator frequencies.

2. Measuring instrument according to Claim 1, characterized in that the evaluation circuit connected to the output of the oscillator (20) is a microcontroller.

3. Measuring instrument according to Claim 1, characterized in that the evaluation circuit connected to the output of the oscillator (20) is a microcontroller by means of which the propagation time (L) of the oscillator (20) is determined from the measured oscillation frequencies.

4. Measuring instrument according to Claim 1, characterized in that the oscillator (20) contains a comparator (21) which is connected to an RC network.

5. Measuring instrument according to Claim 1, characterized in that the control circuit (30) contains at least one gate (31, 32) which has tristate outputs (314, 315, 324, 325) and which is connected to a resistance network.

6. Method for determining the alcohol content of a mixture using the measuring instrument according to one of the preceding claims, characterized in that control voltages which are supplied to the oscillator (20) are generated in the control circuit (30), and in that at least three oscillator frequencies from which a corresponding number of parameters of the measuring circuit (1) are determined are generated by varying the control voltage.

7. Method according to Claim 10, characterized in that the capacitance and the conductance of the capacitor are determined from the measured oscillator frequencies, and the relative dielectric constant ($\varepsilon_r$) of the mixture is determined from the capacitance and from the conductance.

**Revendications**

1. Appareil de mesure pour la détermination de la teneur en alcool d'un mélange par mesure de la capacité et de la conductance d'un condensateur, qui est constitué d':
   - une première électrode, qui est formée par une partie de la paroi d'un boîtier (2), et
   - une seconde électrode, qui est formée par un élément formant capteur (3) autour duquel circule le mélange, et
   comportant un circuit de mesure (1), qui est relié électriquement au condensateur (2,3) qui comporte un oscillateur (20), à partir de la fréquence duquel est déterminée la capacité du condensateur (2,3), caractérisé par le fait
   - qu'une entrée (P) de l'oscillateur (20) est reliée à un circuit de commande (30), qui produit au moins trois tensions de commande différentes pour l'oscillateur (20),
   - que la sortie de l'oscillateur (20) est reliée à un circuit d'évaluation, qui mesure la fréquence de l'oscillateur, qui s'établit pour chacune de ces tensions, et
   - que la capacité ($C_p$) et la conductance ($R_p$) du condensateur (2,3) sont déterminées à partir des fréquences mesurées de l'oscillateur.

2. Appareil de mesure suivant la revendication 1, caractérisé par le fait que le circuit d'évaluation, qui est relié à la sortie de l'oscillateur (20), est un microcontrôleur.

3. Appareil de mesure suivant la revendication 1, caractérisé par le fait que le circuit d'évaluation, qui est relié à la sortie de l'oscillateur (20), est un microcontrôleur, qui détermine le temps de transit (L) dans l'oscillateur (20), à partir des fréquences mesurées de l'oscillateur.

4. Appareil de mesure suivant la revendication 1, caractérisé par le fait que l'oscillateur (20) contient un comparateur (21), qui est connecté à un réseau RC.

5. Appareil de mesure suivant la revendication 1, caractérisé par le fait que le circuit de commande (3) contient au moins une porte (31,32), qui possède des sorties trois-états (314, 315, 324, 325) et est connecté à un réseau de résistances.

6. Procédé pour déterminer la teneur en alcool d'un mélange au moyen de l'appareil de mesure suivant l'une des revendications précédentes, caractérisé par le fait que dans le circuit de commande (3) sont produites des tensions de commande, qui sont envoyées à l'oscillateur (20), et qu'au moyen d'une modification de la tension de commande, on forme au moins trois fréquences de l'oscillateur, à partir desquelles sont déterminés un nombre correspondant de paramètres du circuit de mesure (1).

7. Procédé suivant la revendication 6, caractérisé par le fait que la capacité et la conductance du condensateur sont déterminées à partir des fréquences mesurées de l'oscillateur et que la constante diélectrique relative ($e_r$) du mélange est déterminée à partir de la conductance.

# FIG 1

# FIG 2

# FIG 3a

# FIG 3b

## FIG 4

# FIG 5

# FIG 6